(19) Europäisches Patentamt
European Patent Office
Office européen des brevets

(11) **EP 3 667 922 B1**

(12) **FASCICULE DE BREVET EUROPEEN**

(45) Date de publication et mention
de la délivrance du brevet:
**23.06.2021 Bulletin 2021/25**

(51) Int Cl.:
**H03L 7/24** *(2006.01)*

(21) Numéro de dépôt: **19214884.9**

(22) Date de dépôt: **10.12.2019**

(54) **OSCILLATEUR VERROUILLE PAR INJECTION A IMPEDANCE DE CHARGE VARIABLE**

DURCH EINSPRITZUNG GERASTETER OSZILLATOR MIT VARIABLER LASTIMPEDANZ

OSCILLATOR LOCKED BY INJECTION WITH VARIABLE LOAD IMPEDANCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.12.2018 FR 1872714**

(43) Date de publication de la demande:
**17.06.2020 Bulletin 2020/25**

(73) Titulaire: **Commissariat à l'énergie atomique et aux énergies alternatives 75015 Paris (FR)**

(72) Inventeur: **BADETS, Franck 38054 GRENOBLE CEDEX 09 (FR)**

(74) Mandataire: **Brevalex 95, rue d'Amsterdam 75378 Paris Cedex 8 (FR)**

(56) Documents cités:
**EP-A1- 3 312 568    US-A1- 2010 134 152 US-B1- 6 317 008**

Remarques:
Le dossier contient des informations techniques présentées postérieurement au dépôt de la demande et ne figurant pas dans le présent fascicule.

**Description**

**DOMAINE TECHNIQUE ET ART ANTÉRIEUR**

L'invention porte sur le domaine des oscillateurs verrouillés par injection, notamment celui des oscillateurs à très faible consommation électrique et/ou utilisés dans des environnements à fortes variations de température.

Tout oscillateur a une fréquence propre, ou fréquence d'oscillation libre, $f_0$, c'est-à-dire une fréquence à laquelle oscille l'oscillateur lorsqu'il n'est soumis à aucun signal d'injection, également appelé signal de synchronisation. L'oscillateur peut osciller à une fréquence $f_{inj}$ d'un signal d'injection reçu par l'oscillateur, envoyé par exemple depuis un autre oscillateur, sous réserve que la puissance du signal d'injection soit suffisante et que la fréquence $f_{inj}$ ne soit pas trop éloignée de la fréquence propre $f_0$ de l'oscillateur. Cette propriété, appelée verrouillage par injection, est commune à tous les types d'oscillateurs : électriques, mécaniques, optiques, biologiques, etc.

Les oscillateurs sont caractérisés par une plage de fréquence de verrouillage qui correspond à la plage de fréquence du signal d'injection qui entraine le verrouillage de l'oscillateur sur la fréquence $f_{inj}$. Cette plage de fréquence dépend notamment de la topologie de l'oscillateur et de la puissance du signal d'injection.

Les oscillateurs verrouillés par injection sont principalement utilisés dans les circuits radiofréquences et millimétriques comme multiplieurs ou diviseurs de fréquence.

Les oscillateurs verrouillés par injection peuvent être utilisés également comme déphaseur. En effet, lorsque l'oscillateur est verrouillé par un signal d'injection de fréquence $f_{inj}$, le déphasage du signal de sortie de l'oscillateur (qui a pour fréquence $f_{inj}$) par rapport au signal d'injection est fonction de l'écart de fréquence $f_{inj}$ - $f_0$. En modifiant la fréquence propre $f_0$ de l'oscillateur, par exemple en appliquant un signal sur une entrée analogique de contrôle de la fréquence propre $f_0$ de l'oscillateur (comme c'est le cas pour un oscillateur commandé en tension, ou VCO), il est possible de réaliser un déphaseur programmable.

Un tel déphaseur peut être utilisé pour former un circuit d'interface de capteur servant à détecter une activité d'un capteur. Le document EP 3 312 568 A1 décrit par exemple l'utilisation d'un tel déphaseur dans un circuit d'interface de capteur.

Dans le domaine de l'Internet des Objets (IOT), on cherche à réaliser des interfaces de capteurs ayant une très faible consommation électrique et qui fonctionnent correctement même lorsqu'elles sont soumises à d'importantes variations de tension d'alimentation et de température. Une telle interface de capteur peut réaliser un traitement de signal numérique dans le domaine temporel, c'est-à-dire convertir un signal analogique mesuré en un signal numérique temporel (dont l'information correspond par exemple à la phase ou à la fréquence du signal), ce qui permet d'obtenir une bonne robustesse par rapport aux variations de température et d'alimentation. Plus particulièrement, ces architectures font appel à des circuits assurant une conversion analogique / temps qui peuvent être réalisés par des oscillateurs verrouillés par injection utilisés en déphaseur.

Le procédé généralement utilisé pour verrouiller par injection un oscillateur électrique consiste à appliquer un courant de fréquence sur un nœud de l'oscillateur, ou à appliquer une tension de fréquence sur une branche de l'oscillateur. En pratique, il est plus facile d'injecter un courant dans un nœud d'un oscillateur que de superposer une tension à une branche de l'oscillateur. Par contre, les signaux communément utilisés sont généralement des tensions. Une solution proposée consiste à injecter une tension de fréquence sur la grille d'un transistor afin de la convertir en un courant.

Un autre mode de verrouillage utilisé pour réaliser un verrouillage sur une fréquence harmonique de consiste à moduler la polarisation de l'oscillateur en fonction du signal d'injection.

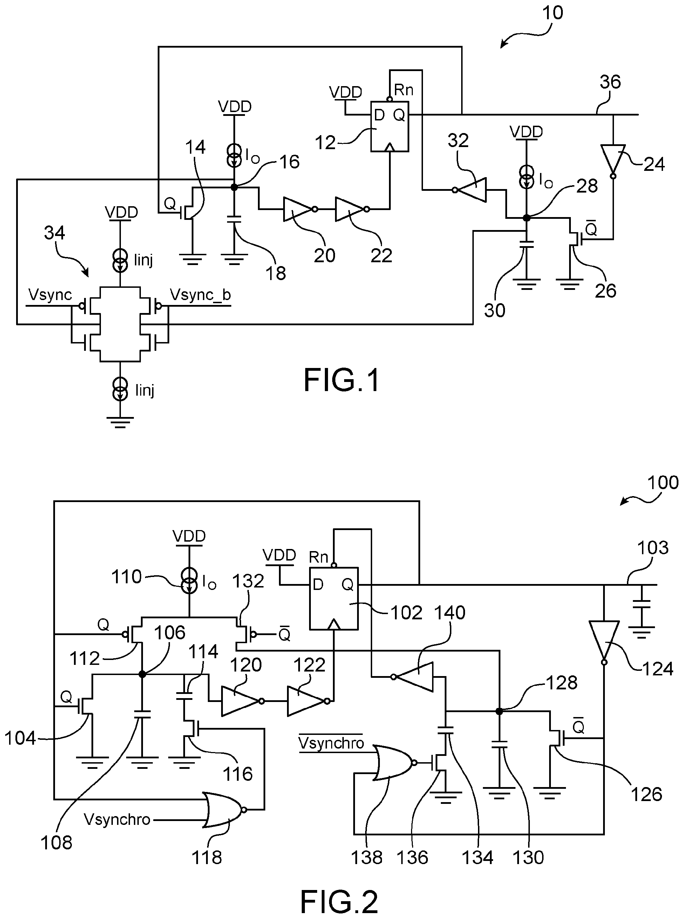

La figure 1 représente schématiquement un oscillateur 10 verrouillé par injection utilisé comme déphaseur. L'oscillateur 10 comporte une bascule D 12 ayant une entrée de données D sur laquelle un potentiel électrique d'alimentation VDD est appliqué. Une sortie Q de la bascule D 12 est reliée à la grille d'un premier transistor 14. L'une des électrodes de source ou de drain du premier transistor 14 est reliée à la masse et l'autre des électrodes de source ou de drain du premier transistor 14 est reliée à un premier nœud 16. Une première électrode d'un premier condensateur 18 est reliée à ce premier nœud 16. Une deuxième électrode du premier condensateur 18 est reliée à la masse. Un courant de charge $I_0$ est appliqué sur le premier nœud 16. Ce courant de charge $I_0$ correspond ici à un signal de commande reçu par l'oscillateur 10 (la réception de ce signal est symbolisée par une source de courant sur la figure 1), par exemple un signal délivré par un capteur lorsque l'oscillateur 10 est utilisé pour former une interface de capteur. Le premier nœud 16 est également relié à l'entrée d'un premier inverseur 20. La sortie du premier inverseur 20 est reliée à l'entrée d'un deuxième inverseur 22. La sortie du deuxième inverseur 22 est reliée à l'entrée d'horloge de la bascule D 12.

La sortie Q de la bascule D 12 est également reliée à l'entrée d'un troisième inverseur 24 dont la sortie est reliée à la grille d'un deuxième transistor 26. L'une des électrodes de source ou de drain du deuxième transistor 26 est reliée à la masse et l'autre des électrodes de source ou de drain du deuxième transistor 26 est reliée à un deuxième nœud 28. Une première électrode d'un deuxième condensateur 30 est reliée au deuxième nœud 28, et une deuxième électrode du deuxième condensateur 30 est reliée à la masse. Le courant $I_0$ est appliqué sur le deuxième nœud 28. Le deuxième nœud 28 est également relié à l'entrée d'un quatrième inverseur 32. La sortie du quatrième inverseur 32 est reliée à une entrée de réinitialisation de la bascule D 12.

L'oscillateur 10 comporte également un circuit d'injection 34. Le circuit d'injection 34 comporte quatre transistors MOS utilisés comme interrupteurs et reliés entre eux de manière similaire aux pompes de charge des boucles de verrouillage de phase. Des signaux de synchronisation $V_{sync}$ et $V_{sync\_b}$ (signal inverse de $V_{sync}$), correspondant à des signaux périodiques de fréquence $f_{inj}$, sont appliqués sur les grilles des quatre transistors MOS, afin que le circuit 34 délivre sur les nœuds 16 et 28 un signal d'injection de fréquence $f_{inj}$, correspondant à un courant $I_{inj}$. Les signaux de synchronisation $V_{sync}$ et $V_{sync\_b}$ sont par exemple fournis par un autre oscillateur.

Le circuit 34 a pour fonction d'ajouter et de retrancher, de manière alternée, le courant $I_{inj}$ du courant $I_0$ au rythme des signaux de synchronisation, c'est-à-dire à la fréquence $f_{inj}$. Les premier et deuxième condensateurs 18, 30 sont chargés alternativement. L'oscillateur 10 oscille à la fréquence des signaux de synchronisation, c'est-à-dire à la fréquence $f_{inj}$, et ajuste le déphasage du signal obtenu sur une sortie 36 de l'oscillateur 10 (correspondant au signal délivré sur la sortie Q de la bascule D 12) par rapport au signal d'injection de façon à ce que la valeur du courant de charge traversant les condensateurs 18 et 30 soit égale à la valeur du courant qu'il aurait fallu utiliser pour que, sans injection, la fréquence d'oscillation libre de l'oscillateur 10 soit égale à la fréquence du signal d'injection.

Dans l'oscillateur 10, le déphasage $\varphi$ obtenu entre le signal délivré sur la sortie 36 et le signal d'injection s'exprime par l'équation suivante :

$$\varphi = \frac{\pi}{2}\left[\frac{I_0}{I_{inj}}\left(\frac{f_{inj}}{f_0} - 1\right) + 1\right]$$

Si les courants $I_0$ et $I_{inj}$ étaient issus d'une même source de courant, ces courants présenteraient la même dépendance en température, ce qui permettrait de minimiser les variations du déphasage $\varphi$ en fonction de la température. Toutefois, en pratique, ces courants ne sont pas issus d'une même source de courant et les erreurs d'appariement ne permettent pas de garantir une même dépendance à la température des différentes sources de courant, surtout pour des grandes variations de température par exemple supérieures à 100°C. Ces deux grandeurs, $I_0$ et $I_{inj}$, ayant dans le cas général des comportements en température différents, la plage de fréquence de verrouillage de l'oscillateur 10 dépend donc de la température de l'environnement de fonctionnement de l'oscillateur 10. Un tel oscillateur 10 n'est pas donc pas adapté pour fonctionner dans des environnements soumis à des contraintes en température importantes.

En outre, les courants $I_{inj}$ et $I_0$ dépendent de la tension d'alimentation $V_{DD}$ de l'oscillateur 10. Les défauts d'appariement des sources de courant desquelles sont issus ces courants empêchent d'obtenir une dépendance identique à la tension d'alimentation. Ainsi, le déphasage obtenu dépend également de la tension d'alimentation $V_{DD}$ de l'oscillateur 10.

De plus, l'oscillateur 10 requiert que le courant $I_{inj}$ soit constamment fourni pour qu'il puisse se verrouiller. La consommation électrique liée à cette injection de courant est pénalisante, notamment lorsque l'oscillateur 10 est destiné à être utilisé pour des applications à très faible consommation électrique, comme par exemple dans le domaine de l'IOT.

## EXPOSÉ DE L'INVENTION

Un but de la présente invention est de proposer un oscillateur verrouillé par injection ayant une consommation électrique réduite par rapport aux oscillateurs verrouillés par injection de l'art antérieur, et qui soit adapté pour fonctionner dans des environnements soumis à d'importants changements de température.

Pour cela, la présente invention propose un oscillateur verrouillé par injection comprenant au moins :

- une ou plusieurs entrées de commande destinées à recevoir un ou plusieurs signaux de commande, l'oscillateur étant configuré tel que la valeur de sa fréquence propre, ou fréquence d'oscillation libre, soit fonction de l'amplitude du ou des signaux de commande ;
- une entrée de synchronisation destinée à recevoir un signal de synchronisation périodique, l'oscillateur étant configuré pour délivrer, lorsque l'oscillateur est verrouillé à la fréquence du signal de synchronisation, un signal de sortie de fréquence égale à la fréquence du signal de synchronisation et tel qu'un déphasage entre le signal de sortie et le signal de synchronisation soit fonction d'une différence entre la fréquence propre de l'oscillateur et la fréquence du signal de synchronisation ;
- une première impédance de charge, l'oscillateur étant configuré tel qu'un signal de charge, correspondant par exemple à un courant de charge, soit appliqué sur la première impédance de charge ;
- une deuxième impédance de charge ;
- un premier composant de couplage configuré pour coupler périodiquement, à la fréquence du signal de synchronisation, et en parallèle ou en série, la deuxième impédance de charge à la première impédance de charge.

Un tel oscillateur propose un nouveau mode de verrouillage par injection permettant de réduire la consommation de l'oscillateur. En effet, dans cet oscillateur, le verrouillage par injection est réalisé en changeant périodiquement, à la fréquence du signal de synchronisation, la valeur de l'impédance de charge qui passe de la valeur de la première impédance de charge seule à la valeur de l'ensemble formé des première et deuxième impédances de charge. Dans cet oscillateur, le verrouillage n'est donc pas obtenu en injectant périodiquement un courant d'injection dans l'oscillateur mais en modifiant périodiquement la valeur de l'impédance de charge, ce qui permet de réduire la consommation électrique de l'oscillateur. Par exemple, un tel oscillateur peut consommer quelques nW seulement.

Un tel oscillateur est donc avantageusement utilisé dans les domaines qui sont contraignants en termes de consommation électrique, comme par exemple celui de l'IOT.

De plus, dans cet oscillateur, la plage de fréquence de verrouillage de l'oscillateur ne dépend pas de l'amplitude du signal d'injection et de l'amplitude du signal de l'oscillateur aux bornes de la branche de l'oscillateur qui reçoit le signal d'injection. Dans l'oscillateur proposé, la plage de fréquence de verrouillage ne dépend plus que du rapport de la variation de la valeur de l'impédance de charge par rapport à sa valeur nominale. Cet oscillateur permet donc d'avoir une plage de fréquence de verrouillage mieux maitrisée et indépendante des variations de température et de la tension d'alimentation.

L'oscillateur peut être un oscillateur à relaxation.

Le premier composant de couplage peut comporter au moins un premier transistor de couplage couplé en série ou en parallèle à la deuxième impédance de charge. Lorsque le premier transistor de couplage est couplé en série à la deuxième impédance de charge, celui-ci peut relier ou non la deuxième impédance de charge, qui peut être couplée en parallèle à la première impédance de charge, suivant son état passant ou bloqué. Lorsque le premier transistor de couplage est couplé en parallèle à la deuxième impédance de charge, celui-ci peut court-circuiter ou non la deuxième impédance de charge, qui peut être couplée en série à la première impédance de charge, suivant son état passant ou bloqué.

Dans un premier mode de réalisation, l'oscillateur peut comporter en outre au moins :

- une troisième impédance de charge, l'oscillateur étant configuré tel que le signal de charge soit appliqué sur la troisième impédance de charge ;
- une quatrième impédance de charge ;
- un deuxième composant de couplage configuré pour coupler périodiquement, à la fréquence du signal de synchronisation, et en parallèle ou en série, la quatrième impédance de charge à la troisième impédance de charge.

Dans le premier mode de réalisation, l'oscillateur peut comporter en outre :

- une bascule dont une entrée d'horloge est couplée aux première et deuxième impédances de charge, dont une entrée de réinitialisation est couplée aux troisième et quatrième impédances de charge, et dont une sortie est configurée pour délivrer le signal de sortie de l'oscillateur, ou
- un verrou dont une entrée de mise à un état bas du verrou est couplée aux première et deuxième impédances de charge, dont une entrée de mise à l'état haut du verrou est couplée aux troisième et quatrième impédances de charge, et dont une sortie est configurée pour délivrer le signal de sortie de l'oscillateur.

La bascule est par exemple une bascule D. Le verrou est par exemple un verrou RS.

Dans ce cas, une grille du premier transistor de couplage peut être couplée à une sortie d'une première porte logique NON-OU dont une première entrée est couplée à la sortie de la bascule ou du verrou et dont une deuxième entrée est configurée pour recevoir le signal de synchronisation.

Le deuxième composant de couplage peut comporter au moins un deuxième transistor de couplage couplé en série ou en parallèle à la quatrième impédance de charge.

Dans ce cas, une grille du deuxième transistor de couplage peut être couplée à une sortie d'une deuxième porte logique NON-OU dont une première entrée est couplée à une sortie inversée de la bascule ou du verrou et dont une deuxième entrée est configurée pour recevoir un signal inverse du signal de synchronisation.

De plus, l'oscillateur peut comporter la bascule ou le verrou et :

- un premier transistor de décharge couplé en parallèle aux première et deuxième impédances de charge et dont la grille est couplée à la sortie de la bascule ou du verrou ;
- un deuxième transistor de décharge couplé en parallèle aux troisième et quatrième impédances de charge et dont la grille est couplée à une sortie inversée de la bascule ou du verrou.

Les premier et deuxième transistors de décharge assurent dans ce cas l'alternance des phases de charge et décharge des impédances de charge.

De plus, l'oscillateur peut comporter la bascule ou le verrou et :

- un premier transistor d'entrée dont une grille est couplée à la sortie de la bascule ou du verrou et configuré tel que le signal de charge, correspondant à un courant de charge, soit appliqué ou non sur la première impédance de charge en fonction de l'état passant ou bloqué du premier transistor d'entrée ;
- un deuxième transistor d'entrée dont une grille est couplée à une sortie inversée de la bascule ou du verrou et configuré tel que le signal de charge soit appliqué ou non sur la troisième impédance de charge en fonction de l'état passant ou bloqué du deuxième transistor d'entrée.

De tels transistors d'entrée permettent de réduire encore plus la consommation électrique de l'oscillateur car ils permettent de n'appliquer le signal de charge sur les impédances de charge que lors des phases de charge de ces impédances.

L'entrée de commande ou une première des entrées de commande peut être couplée à la première impédance de charge telle que le signal de commande ou un premier des signaux de commande forme le signal de charge. Dans ce cas, la fréquence propre à laquelle oscille l'oscillateur peut être commandée par l'intermédiaire de l'amplitude du signal de charge.

Chacune des impédances de charges peut comporter au moins un condensateur, ou au moins un composant capacitif. En variante, il est également possible que les impédances de charges correspondent à des bobines, ou des composants inductifs.

L'oscillateur peut être tel que :

- la première impédance de charge comporte au moins un premier condensateur et, lorsque l'oscillateur comporte la troisième impédance de charge, la troisième impédance de charge comporte au moins un deuxième condensateur, ou
- la première impédance de charge comporte au moins un premier transducteur capacitif formant l'entrée de commande ou une deuxième des entrées de commande, la valeur de la fréquence propre de l'oscillateur étant fonction de la valeur de la capacité du premier transducteur capacitif, et, lorsque l'oscillateur comporte la troisième impédance de charge, la troisième impédance de charge comporte au moins un deuxième transducteur capacitif formant l'entrée de commande ou la deuxième des entrées de commande, la valeur de la fréquence propre de l'oscillateur étant fonction de la valeur de la capacité du deuxième transducteur capacitif.

Dans la configuration ci-dessus, la fréquence propre à laquelle oscille l'oscillateur peut donc être fonction des valeurs des capacités des transducteurs capacitifs, ces valeurs de capacités pouvant dépendre par exemple d'un ou plusieurs signaux (par exemple une pression, un champ électrique, une force, etc.) reçus par les transducteurs capacitifs et correspondant au signal ou aux signaux de commande.

L'oscillateur peut comporter la bascule ou le verrou, et chacune des impédances de charge peut être couplée à la bascule ou au verrou par l'intermédiaire d'au moins un inverseur dont une entrée de contrôle de tension de seuil forme l'entrée de commande ou une troisième des entrées de commande. Dans ce cas, la fréquence propre à laquelle oscille l'oscillateur peut être fonction de la valeur de la ou des tensions de seuil du ou des inverseurs couplant les impédances de charges à la bascule ou au verrou du signal, et donc fonction du ou des signaux de commande appliqués sur l'entrée de contrôle du ou des inverseurs.

Dans un deuxième mode de réalisation, l'oscillateur peut être un oscillateur harmonique comprenant au moins un circuit LC, c'est-à-dire un circuit comprenant au moins un composant capacitif et au moins un composant inductif.

Dans un troisième mode de réalisation, l'oscillateur peut être un oscillateur en anneau comprenant au moins un nombre d'inverseurs impair et supérieur ou égal à trois, et tels qu'une sortie de l'un des inverseurs soit couplée à la première impédance de charge.

Selon une variante avantageuse de ce troisième mode de réalisation, une sortie de chacun des inverseurs peut être couplée à une impédance de charge et à un composant de couplage configuré pour coupler périodiquement, à la fréquence du signal de synchronisation, et en parallèle ou en série, une autre impédance de charge à ladite impédance de charge.

L'invention concerne également un circuit d'interface pour capteur, comprenant au moins un oscillateur verrouillé par injection tel que décrit précédemment, et un deuxième oscillateur dont une sortie est couplée à la deuxième entrée de l'oscillateur verrouillé par injection.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un oscillateur verrouillé par injection utilisé comme déphaseur ;
- la figure 2 représente un oscillateur verrouillé par injection, objet de la présente invention, selon un premier mode de réalisation ;
- la figure 3 représente un oscillateur verrouillé par injection, objet de la présente invention, selon une première variante du premier mode de réalisation ;
- la figure 4 représente un oscillateur verrouillé par injection, objet de la présente invention, selon une deuxième variante du premier mode de réalisation ;
- la figure 5A représente un oscillateur verrouillé par injection, objet de la présente invention, selon une troisième variante du premier mode de réalisation ;
- la figure 5B représente un inverseur à tension de seuil commandée utilisé dans l'oscillateur verrouillé par injection selon la troisième variante du premier mode de réalisation ;
- la figure 6 représente un oscillateur verrouillé par injection, objet de la présente invention, selon un deuxième mode de réalisation ;
- la figure 7 représente un oscillateur verrouillé par injection, objet de la présente invention, selon un troisième mode de réalisation ;

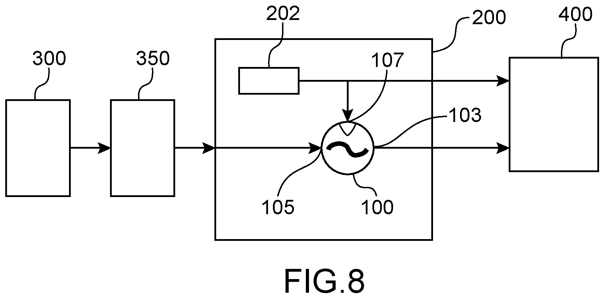

- la figure 8 représente un circuit d'interface pour capteur, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

Un oscillateur 100 verrouillé par injection selon un premier mode de réalisation est décrit ci-dessous en lien avec la figure 2.

L'oscillateur 100 comporte une bascule 102 qui, dans le premier mode de réalisation, correspond à une bascule D. La bascule 102 comporte une entrée de données D couplée à un potentiel électrique d'alimentation VDD. Une sortie Q de la bascule D 102 est reliée à une sortie 103 de l'oscillateur 100 et est couplée à la grille d'un premier transistor de décharge 104. Une première électrode du premier transistor de décharge 104, correspondant au drain du premier transistor de décharge 104 qui est de type N, est couplée à un premier nœud 106. Une deuxième électrode du premier transistor de décharge 104, correspondant à la source du premier transistor de décharge 104, est couplée à la masse.

L'oscillateur 100 comporte également une première impédance de charge 108. Dans ce premier mode de réalisation, cette première impédance de charge 108 correspond à un premier condensateur, ou plus généralement un premier composant capacitif, de valeur $C_1$. Une première électrode du premier condensateur est couplée au premier nœud 106, et une deuxième électrode du premier condensateur est couplée à la masse.

Un courant de charge $I_0$, correspondant ici à un signal de commande reçu par l'oscillateur 100 (ce signal de commande est symbolisée par une source de courant 110 sur la figure 2) est appliqué sur le premier nœud 106, et donc sur la première impédance de charge 108, à travers un premier transistor d'entrée 112. La sortie Q de la bascule 102 est couplée à la grille du premier transistor d'entrée 112.

L'oscillateur 100 comporte en outre une deuxième impédance de charge 114, ainsi qu'un premier composant de couplage 116 commandé et configuré pour coupler périodiquement la deuxième impédance de charge 114 à la première impédance de charge 108. Dans ce premier mode de réalisation, cette deuxième impédance de charge 114 correspond à un deuxième condensateur, ou deuxième composant capacitif, de valeur $C_{synchro1}$ et le premier composant de couplage 116 correspond à un premier transistor de couplage 116. Une première électrode du deuxième condensateur est reliée au premier nœud 106. Une deuxième électrode du deuxième condensateur est reliée à une première électrode du premier transistor de couplage 116, et correspond au drain du premier transistor de couplage 116 qui est de type N. Une deuxième électrode du premier transistor de couplage 116, correspondant à la source du premier transistor de couplage 116, est couplée à la masse.

La grille du premier transistor de couplage 116 est couplée à la sortie d'une première porte logique NON-OU 118 comprenant une première entrée couplée à la sortie Q de la bascule 102 et une deuxième entrée sur laquelle un signal de synchronisation $V_{synchro}$, de fréquence $f_{synchro}$, est appliqué. Le signal de synchronisation correspond par exemple à un signal carré dont les valeurs haute et basse sont environ égales à celles du signal délivré sur la sortie Q de la bascule 102. Grâce à la première porte logique NON-OU 118, la deuxième impédance de charge 114 est couplée en parallèle de la première impédance de charge 108 lorsque le signal de synchronisation $V_{synchro}$ et le signal de sortie de la bascule 102 sont tous les deux à l'état bas.

Le premier nœud 106 est également couplé à l'entrée d'un premier inverseur 120, la sortie de ce premier inverseur 120 étant couplée à l'entrée d'un deuxième inverseur 122. La sortie du deuxième inverseur 122 est couplée à l'entrée d'horloge de la bascule 102. Ces inverseurs 120, 122 permettent de redresser le front du signal obtenu sur le premier nœud 106 avant son application sur l'entrée d'horloge de la bascule 102.

La sortie Q de la bascule 102 est également couplée à l'entrée d'un troisième inverseur 124. De manière alternative, le signal obtenu sur la sortie du troisième inverseur 124, correspondant au signal de sortie inversée $\overline{Q}$, pourrait être obtenu sur une sortie inversée de la bascule 102. La sortie du troisième inverseur 124 est couplée à la grille d'un deuxième transistor de décharge 126.

Une première électrode du deuxième transistor de décharge 126, correspondant au drain du deuxième transistor de décharge 126 qui est de type N, est couplée à un deuxième nœud 128. Une deuxième électrode du deuxième transistor de décharge 126, correspondant à la source du deuxième transistor de décharge 126, est couplée à la masse.

L'oscillateur 100 comporte également une troisième impédance de charge 130. Dans ce premier mode de réalisation, cette troisième impédance de charge 130 correspond à un troisième condensateur, ou troisième composant capacitif, de valeur $C_2$. Une première électrode du troisième condensateur est couplée au deuxième nœud 128, et une deuxième électrode du troisième condensateur est couplée à la masse.

Le courant de charge $I_0$ est appliqué sur le deuxième nœud 128, et donc sur la troisième impédance de charge 130, à travers un deuxième transistor d'entrée 132. Le signal de sortie inversée $\overline{Q}$ de la bascule 102 est appliqué sur la grille du deuxième transistor d'entrée 132.

L'oscillateur 100 comporte en outre une quatrième impédance de charge 134, ainsi qu'un deuxième composant de couplage 136 commandé et configuré pour coupler périodiquement la quatrième impédance de charge 134 à la troisième impédance de charge 108. Dans ce premier mode de réalisation, cette quatrième impédance de charge 134 correspond à un quatrième condensateur, ou quatrième composant capacitif, de valeur $C_{synchro2}$, et le deuxième composant de couplage 136 correspond à un deuxième transistor de couplage.

Les valeurs des condensateurs de l'oscillateur 100 sont ici telles que $C_1/C_{synchro1} = C_2/C_{synchro2}$.

Une première électrode du quatrième condensateur est reliée au deuxième nœud 128. Une deuxième électrode du quatrième condensateur est reliée à une première électrode du deuxième transistor de couplage, correspondant au drain du deuxième transistor de couplage qui est de type N. Une deuxième électrode du deuxième transistor de couplage, correspondant à la source du deuxième transistor de couplage, est couplée à la masse.

La grille du deuxième transistor de couplage est couplée à la sortie d'une deuxième porte logique NON-OU 138 comprenant une première entrée couplée à la sortie du troisième inverseur 124 et une deuxième entrée sur laquelle un signal inverse du signal de synchronisation $V_{synchro}$, appelé $\overline{V_{synchro}}$ et de fréquence $f_{synchro}$, est appliqué. Grâce à la deuxième porte logique NON-OU 138, la quatrième impédance de charge 134 est couplée en parallèle de la troisième impédance de charge 130 lorsque le signal $\overline{V_{synchro}}$ et le signal de sortie inversée $\overline{Q}$ de la bascule 102 sont tous les deux à l'état bas.

Le deuxième nœud 128 est également couplé à l'entrée d'un quatrième inverseur 140 dont la sortie est couplée à une entrée de réinitialisation de la bascule 102. Cet inverseur 140 permet de redresser le front du signal obtenu sur le deuxième nœud 128 avant son application sur l'entrée de réinitialisation de la bascule 102.

Dans l'oscillateur 100 décrit ci-dessus, les transistors 104, 112, 116, 126, 132 et 136 sont par exemple des transistors MOSFET. D'autres types de transistor peuvent toutefois être utilisés.

Dans l'oscillateur 100 représenté sur la figure 2, le signal de commande correspondant au courant de charge $I_0$ permet de commander directement la fréquence propre de l'oscillateur 100. La valeur de la fréquence propre $f_0$ de l'oscillateur 100 est fonction de l'amplitude de courant de charge $I_0$, et donc de l'amplitude du signal de commande reçu par l'oscillateur 100. Ce signal de commande peut correspondre à un signal de mesure reçu par l'oscillateur 100, ou bien correspondre à un signal obtenu à partir d'un signal de mesure, par exemple un signal délivré en sortie d'un amplificateur à transconductance dont une entrée reçoit le signal de mesure.

Dans cet oscillateur 100, la synchronisation n'est pas réalisée par une injection de courant (ou d'une tension) venant s'ajouter puis se retrancher au signal de commande de l'oscillateur 100 à la fréquence du signal de synchronisation, mais par une modification de la valeur de la ou des impédances de charge (les première et troisième impédances de charge 108, 130 dans le premier mode de réalisation décrit ci-dessus) de l'oscillateur 100, réalisée à la fréquence du signal de synchronisation $f_{synchro}$. La valeur de cette ou ces impédances de charge est modifiée en couplant et en découplant périodiquement une ou plusieurs autres impédances de charge (les deuxième et quatrième impédances de charge 114, 134 dans le premier mode de réalisation décrit ci-dessus), en série ou en parallèle (en parallèle dans le premier mode de réalisation décrit ci-dessus) de cette ou ces impédances de charge. Dans le premier mode de réalisation décrit ci-dessus, le premier ensemble de charge comprenant les première et deuxième impédances de charges 108, 114 forme donc une capacité dont la valeur alterne entre les valeurs $C_1$ et $C_1 + C_{synchro1}$. De même, le deuxième ensemble de charge comprenant les troisième et quatrième impédances de charges 130, 134 forme donc une capacité dont la valeur alterne entre les valeurs C$_2$ et C$_2$ + C$_{synchro2}$.

Ainsi, l'oscillateur 100 se verrouille sur la fréquence f$_{synchro}$ du signal de synchronisation V$_{synchro}$ en ajustant la phase du signal délivré sur la sortie 103, de façon à ce que la valeur de l'impédance de charge moyenne de l'oscillateur 100 soit égale à celle qu'il serait nécessaire pour que l'oscillateur 100 soit en oscillation libre (sans signal de synchronisation appliqué en entrée de l'oscillateur 100) à la fréquence f$_{synchro}$ du signal de synchronisation. Ainsi, le déphasage entre le signal de sortie délivré sur la sortie 103 et le signal de synchronisation V$_{synchro}$ est fonction de la différence entre la fréquence propre de l'oscillateur 100 et la fréquence f$_{synchro}$ du signal de synchronisation V$_{synchro}$.

Lorsque C$_1$ = C$_2$ et C$_{synchro1}$ = C$_{synchro2}$, le signal obtenu sur la sortie 103 de l'oscillateur 100 a un rapport cyclique égal à 50 % (sur une période de ce signal de sortie, la durée de l'état haut est égale à celle de l'état bas). Le déphasage φ obtenu entre le signal de synchronisation et le signal délivré sur la sortie 103 de l'oscillateur 100 s'exprime alors par l'équation suivante :

$$\varphi = \pi \left[ \frac{f_{synchro}}{f_0} \left( \frac{C_1}{C_{synchro1}} + 1 \right) - \frac{C_1}{C_{synchro1}} \right]$$

Dans l'équation ci-dessus, les différents termes (rapports C$_1$/C$_{synchro1}$ et f$_{synchro}$/f$_0$) sont indépendants de la température de l'environnement dans lequel l'oscillateur 100 fonctionne lorsque l'oscillateur fournissant le signal V$_{synchro}$ est de même topologie que l'oscillateur verrouillé par injection. La plage de fréquence de verrouillage de l'oscillateur 100 ne dépend donc pas de cette température, mais dépend de la variation de la valeur des ensembles de charge par rapport à leur valeur nominale, c'est-à-dire de la valeur totale des première et deuxième impédances de charges et de la valeur totale des troisième et quatrième impédances de charge par rapport respectivement à la valeur de la première impédance de charge seule et à la valeur de la troisième impédance de charge seule. De plus, la plage de fréquence de verrouillage de l'oscillateur 100 ne dépend pas non plus de l'amplitude des signaux de commande et de synchronisation reçus par l'oscillateur 100.

Selon une variante de réalisation, les valeurs des condensateurs C$_1$ et C$_2$ peuvent être différentes l'une de l'autre. Dans ce cas, le signal obtenu sur la sortie 103 de l'oscillateur 100 a un rapport cyclique α différent 50 %. Dans cette variante, lorsque le rapport cyclique α est supérieure à 50 % et que l'oscillateur 100 ne comporte pas la quatrième impédance de charges 134, le déphasage φ obtenu s'exprime par l'équation suivante :

$$\varphi = 2.\pi.(1 + \frac{C_1}{C_{synchro1}}) \left[ \frac{f_{synchro}}{f_0} + \alpha \left( \frac{C_{synchro1}}{C_1 + C_{synchro1}} \right) - 1 \right]$$

Une telle variante permet notamment que l'oscillateur 100 forme un déphaseur linéaire sur une gamme de phase supérieure à pi.

Dans le premier mode de réalisation décrit ci-dessus, l'oscillateur 100 correspond à un oscillateur à relaxation. Le principe exposé ci-dessus consistant à modifier la valeur de la ou des impédances de charge de l'oscillateur à la fréquence du signal de synchronisation reçu par l'oscillateur peut s'appliquer à des oscillateurs à relaxation différents de celui décrit ci-dessus.

Dans le premier mode de réalisation décrit ci-dessus, l'oscillateur 100 comporte des transistors d'entrée 112, 132 permettant l'envoi du courant de charge I$_0$ sur l'un ou l'autre des nœuds 106, 128 suivant la valeur du signal de sortie délivré sur la sortie Q de la bascule 102. Ces transistors d'entrée 112, 132 permettent donc de réduire la consommation électrique de l'oscillateur 100 du fait que le courant de charge n'est pas appliqué en permanence sur les premier et deuxième nœuds 106, 128. En variante, il est toutefois possible que l'oscillateur 100 ne comporte pas ces transistors d'entrée 112, 132, le courant de charge I$_0$ étant alors envoyé simultanément et en permanence sur les nœuds 106, 128.

Dans l'oscillateur 100 réalisé selon le premier mode de réalisation décrit précédemment, les valeurs des capacités C$_{synchro1}$ et C$_{synchro2}$ (correspondant aux deuxième et quatrième impédances de charge) peuvent être choisies notamment en fonction des variations du courant de charge I$_0$. Si les variations du courant de charge I$_0$ sont faibles, par exemple de l'ordre de 10 %, les valeurs C$_{synchro1}$ et C$_{synchro2}$ des deuxième et quatrième impédances de charge 114, 134 est avantageusement choisie comme étant faible, par exemple de l'ordre d'un dixième des valeurs C$_1$ et C$_2$.

En outre, les valeurs des capacités C$_{synchro1}$ et C$_{synchro2}$ peuvent être inférieures, égales voire même supérieures à celle des capacités C$_1$ et C$_2$.

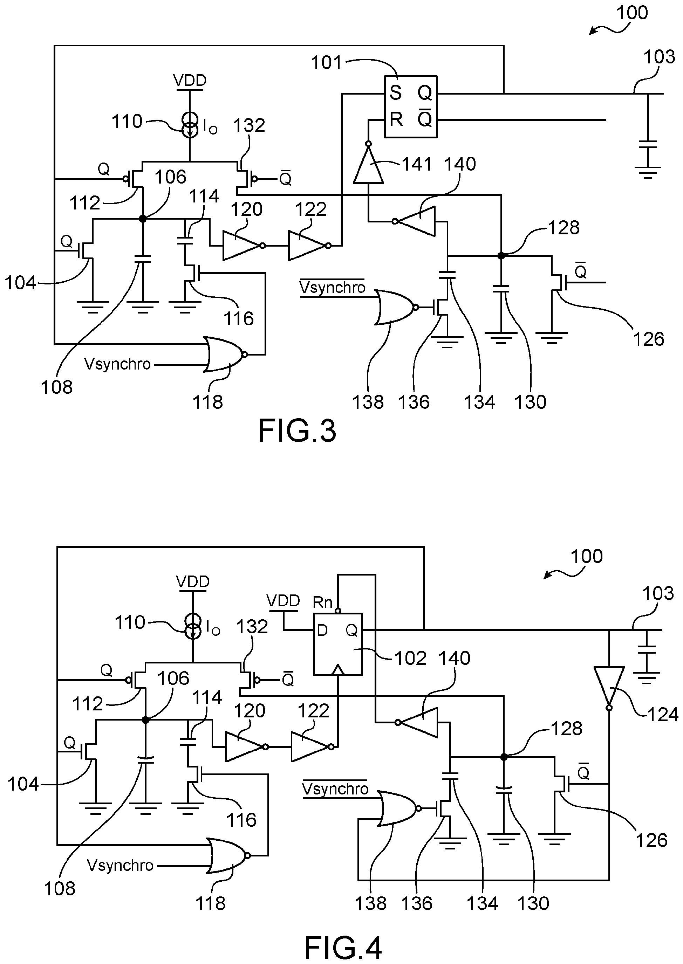

Un oscillateur 100 verrouillé par injection selon une première variante du premier mode de réalisation est décrit ci-dessous en lien avec la figure 3.

Dans cette première variante représentée sur la figure 3, la bascule 102 est remplacée par un verrou 101. Dans l'exemple de réalisation représenté sur la figure 3, le verrou 101 correspond à un verrou RS.

Le premier nœud 106 est couplé à l'entrée S du verrou 101, c'est-à-dire à l'entrée de mise à l'état haut du verrou 101, par l'intermédiaire des premier et deuxième inverseurs 120, 122 reliés en série l'un à l'autre.

Le deuxième nœud 128 est couplé à l'entrée R du verrou 101, c'est-à-dire à l'entrée de mise à l'état bas du verrou 101, par l'intermédiaire du quatrième inverseur 140 et d'un autre inverseur 141 reliés en série l'un à l'autre.

Comme la sortie Q de la bascule 102 de l'oscillateur 100 représenté sur la figure 2, la sortie Q du verrou 101 est ici reliée à la sortie de l'oscillateur 100 et est couplée à la grille du premier transistor de décharge 104, à la grille du premier transistor d'entrée 112 et à la première entrée de la première porte logique NON-OU 118.

La sortie inversée $\overline{Q}$ du verrou 101 est obtenue directement à partir du verrou 101, l'oscillateur 100 représenté sur la figure 3 ne comportant pas le troisième inverseur 124. Cette sortie inversée $\overline{Q}$ du verrou 101 est couplée à la grille du deuxième transistor de décharge 126, à la grille du deuxième transistor d'entrée 132 ainsi qu'à la première entrée de la deuxième porte logique NON-OU 138.

Le fonctionnement de l'oscillateur 100 selon cette première variante du premier mode de réalisation est similaire à celui de l'oscillateur précédemment décrit en lien avec la figure 2.

Un oscillateur 100 verrouillé par injection selon une deuxième variante du premier mode de réalisation est décrit ci-dessous en lien avec la figure 4.

Par rapport à l'oscillateur 100 précédemment décrit en lien avec la figure 2, les première et troisième impédances de charge 108 ne correspondent pas à des condensateurs formant des capacités de valeurs fixes, mais correspondent à des transducteurs capacitifs formant des capacités dont les valeurs varient en fonction d'un signal de commande reçu par les première et troisième impédances de charge 108, 130. Ce signal de commande correspond par exemple à une pression, un champ électrique, ou encore une force reçue par les transducteurs capacitifs.

La valeur de la fréquence propre de l'oscillateur 100 est fonction des valeurs des capacités des première et troisième impédances de charge 108, 130. De manière avantageuse, le courant de charge $I_0$ correspond à un courant de valeur constante, c'est-à-dire dont la valeur ne dépend pas d'un signal de commande reçu par l'oscillateur 100. Ainsi, la fréquence propre de l'oscillateur 100 varie uniquement en fonction des variations du signal de commande reçu par les première et troisième impédances de charge 108, 130.

En variante, il est possible que la valeur du courant de charge $I_0$ soit fonction d'un signal de commande reçu par l'oscillateur 100 et différent de celui faisant varier les valeurs des capacités des première et troisième impédances de charge. La valeur de la fréquence propre de l'oscillateur 100 dépend dans ce cas de l'amplitude de chacun de ces deux signaux de commande.

Selon un autre exemple de réalisation, il est possible que l'oscillateur 100 soit réalisé selon les deux variantes décrites ci-dessus, c'est-à-dire tel qu'il comporte le verrou 101 et les transducteurs capacitifs formant les première et troisième impédances de charge 108, 130.

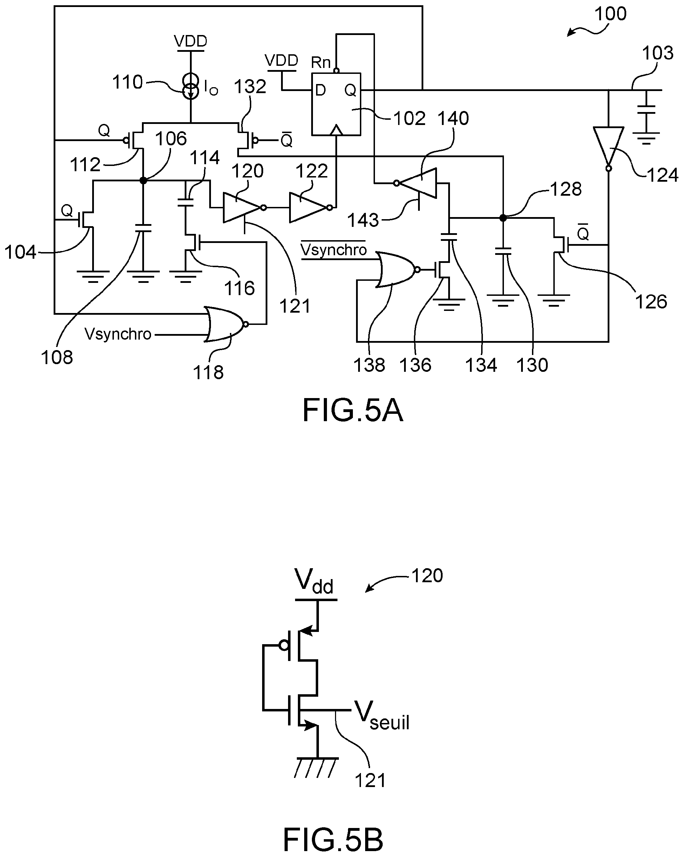

Un oscillateur 100 verrouillé par injection selon une troisième variante du premier mode de réalisation est décrit ci-dessous en lien avec la figure 5A.

Par rapport à l'oscillateur 100 précédemment décrit en lien avec la figure 2, les premier et quatrième inverseurs 120 et 140 de l'oscillateur 100 selon cette troisième variante comporte chacun une entrée de contrôle 121, 143 sur laquelle un signal de commande est appliqué pour commander la tension de seuil des inverseurs 120, 140. Un exemple de réalisation d'un tel inverseur est représenté sur la figure 5B.

La valeur de la fréquence propre de l'oscillateur 100 est fonction des valeurs des tensions de seuil des inverseurs 120, 140, et dépend donc ici de l'amplitude du signal de commande appliqué sur les entrées de contrôle 121, 143 des inverseurs 120, 140. Selon un exemple de réalisation, le courant de charge $I_0$ peut correspondre à un courant de valeur constante, c'est-à-dire dont la valeur ne dépend pas d'un signal de commande reçu par l'oscillateur 100. Ainsi, la valeur de la fréquence propre de l'oscillateur 100 dépend uniquement des valeurs des tensions de seuil des inverseurs 120, 140, et donc des signaux de commande appliqués sur les entrées de contrôle 121, 143 des inverseurs 120 140. En variante, il est toutefois possible que le courant de charge $I_0$ soit fonction d'un autre signal de commande reçu par l'oscillateur 100, la fréquence propre de l'oscillateur 100 variant alors en fonction des amplitudes des deux signaux de commande reçus.

Selon un autre exemple de réalisation, il est possible que les autres inverseurs 122 et 124 de l'oscillateur 100 aient également une entrée de commande permettant de faire varier leur tension de seuil.

Cette troisième variante peut être combinée avec l'une et/ou l'autre des première et deuxième variantes précédemment décrites. Ainsi, l'oscillateur 100 selon cette troisième variante peut comporter également un verrou 101 comme précédemment décrit en lien avec la figure 3, et/ou peut comporter des transducteurs capacitifs formant les première et troisième impédances de charge 108, 130.

Dans un deuxième mode de réalisation, l'oscillateur 100 peut correspondre à un oscillateur harmonique. La figure 3 représente schématiquement une partie d'un tel oscillateur 100.

L'oscillateur 100 selon ce deuxième mode de réalisation comporte une première entrée 142 sur laquelle est appliqué le signal de commande $I_0$. L'oscillateur 100 comporte une deuxième entrée 144 sur laquelle est appliqué le signal de synchronisation $V_{synchro}$.

Dans ce deuxième mode de réalisation, l'oscillateur 100 est de type LC et comporte une inductance, ou bobine, 146 couplée en parallèle à la première impédance de charge 108 correspondant ici à un condensateur. La deuxième impédance de charge 114, correspondant également à un condensateur dans cet exemple de réalisation, est couplée en série avec le premier composant de couplage 116, par exemple un transistor de couplage, l'ensemble étant couplé en parallèle à la première impédance de charge 108. Comme dans le premier mode de réalisation, un signal de fréquence $f_{synchro}$ est appliqué sur la grille du premier transistor de couplage 116.

L'oscillateur 100 comporte également d'autres composants électroniques, comme par exemple une paire croisée de transistors chargée de maintenir les oscillations en compensant les pertes du circuit LC, qui ne sont pas décrits en détails ici.

Comme dans le premier mode de réalisation, l'oscillateur 100 selon ce deuxième mode de réalisation a une impédance de charge dont la valeur est modifiée périodiquement, en fonction de la fréquence du signal de synchronisation appliqué sur l'oscillateur 100. Le déphasage φ obtenu entre le signal de synchronisation et le signal délivré sur la sortie 103 de l'oscillateur 100 est, comme précédemment décrit pour le premier mode de réalisation, représentatif de la différence - $f_{synchro}$.

Dans le deuxième mode de réalisation décrit ci-dessus, l'oscillateur 100 correspond à un oscillateur LC. Le principe exposé ci-dessus consistant à modifier la valeur de l'impédance de charge à la fréquence du signal de synchronisation reçu par l'oscillateur 100 peut s'appliquer à des oscillateurs harmoniques différents de celui décrit ci-dessus.

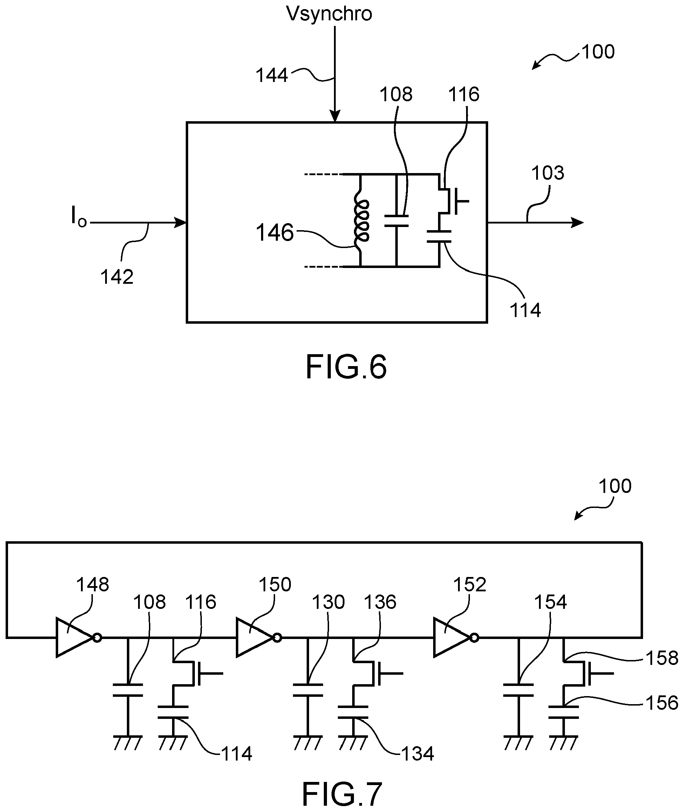

Dans un troisième mode de réalisation, l'oscillateur 100 peut correspondre à un oscillateur en anneau. La figure 7 représente schématiquement un tel oscillateur 100.

L'oscillateur 100 selon ce troisième mode de réalisation comporte trois inverseurs 148, 150 et 152 couplés en série et en boucle, la sortie du troisième inverseur 152 étant couplée à l'entrée du premier inverseur 148. De manière générale, l'oscillateur 100 en anneau comporte un nombre d'inverseurs impair et supérieur ou égal à trois.

La sortie du premier inverseur 148 est couplée à une première électrode de la première impédance de charge 108, la deuxième électrode de la première impédance de charge 108 étant reliée à la masse. Comme dans les deux précédents modes de réalisation, la première impédance de charge 108 correspond à un condensateur.

La deuxième impédance de charge 114 et le premier composant de couplage 116, correspondant respectivement à un condensateur et à un transistor, forment un ensemble couplé en parallèle à la première impédance de charge 108.

La sortie du deuxième inverseur 150 est couplée à une première électrode de la troisième impédance de charge 130, la deuxième électrode de la troisième impédance de charge 130 étant reliée à la masse. Comme dans les deux précédents modes de réalisation, la troisième impédance de charge 130 correspond à un condensateur. La quatrième impédance de charge 134 et le deuxième composant de couplage 136, correspondant respectivement à un condensateur et à un transistor, forment un ensemble couplé en parallèle à la troisième impédance de charge 130.

La sortie du troisième inverseur 152 est couplée à une première électrode d'une cinquième impédance de charge 154, la deuxième électrode de la cinquième impédance de charge 154 étant reliée à la masse. La cinquième impédance de charge 154 correspond à un condensateur. Une sixième impédance de charge 156 et un troisième composant de couplage 158, correspondant respectivement à un condensateur et à un transistor, forment un ensemble couplé en parallèle à la cinquième impédance de charge 154.

Comme dans les précédents modes de réalisation, les grilles des transistors de couplage 116, 136 et 158 reçoivent un signal de fréquence $f_{synchro}$ modulant ainsi à cette fréquence la valeur des impédances de charge couplées aux sorties des inverseurs 148, 150 et 150. Toutefois, les signaux appliqués sur les grilles des transistors de couplage 116, 136, 158 sont déphasés les uns par rapport aux autres afin que la modulation de la valeur de chacune des impédances de charge se produise à des moments différents. Ainsi, sur l'exemple de la figure 7, ces signaux sont déphasés les uns des autres de $2\pi/3$. De manière générale, dans un tel oscillateur en anneau, le déphasage entre les signaux de synchronisation appliqués sur les grilles des transistors de couplage est de $2\pi/n$, avec n correspondant au nombre d'inverseurs de l'oscillateur 100.

Le déphasage φ obtenu entre le signal de synchronisation et le signal délivré sur la sortie 103 de l'oscillateur 100 est similaire à celui précédemment décrit pour le premier mode de réalisation, à un facteur de gain près, c'est-à-dire en fonction du nombre d'inverseurs que comporte l'oscillateur 100.

Dans la configuration représentée sur la figure 7, la sortie de chacun des inverseurs de l'oscillateur 100 est couplée une impédance de charge et à un composant de couplage configuré pour coupler périodiquement, à la fréquence du signal de synchronisation, et en parallèle ou en série, une autre impédance de charge à ladite impédance de charge. En variante, il est possible que seul l'un des inverseurs de l'oscillateur 100 ait sa sortie qui soit couplée à une impédance de charge de valeur variable. Dans ce cas, en reprenant la configuration représentée sur la figure 7, l'oscillateur 100 ne comporterait pas les impédances de charge 134, 156 ni les composants de couplage 136, 158.

Dans un oscillateur à relaxation tel que celui décrit précédemment en lien avec la figure 2, le déphasage est linéaire sur toute la plage de verrouillage de l'oscillateur 100. Par contre, dans d'autres types d'oscillateur comme par exemple dans un oscillateur harmonique, ce déphasage n'est pas linéaire sur toute la plage de verrouillage de l'oscillateur.

Dans ce cas, il est préférable que l'oscillateur soit configuré pour fonctionner sur une partie de cette plage de verrouillage dans laquelle le déphasage varie linéairement.

Dans les modes de réalisation précédemment décrits, la deuxième impédance de charge 114 est couplée en parallèle de la première impédance de charge 108 par le composant de couplage 116. En variante, il est possible que la deuxième impédance de charge 114 soit couplée en série à la première impédance de charge 108 par le composant de couplage 116. Dans ce cas, les première et deuxième impédances de charge 108, 114 peuvent être reliées en série l'une à l'autre, et le composant de couplage 116, formé par exemple par un transistor, peut être couplé en parallèle de la deuxième impédance de charge 114. Ainsi, lorsque le composant de couplage 116 est à l'état bloqué, la deuxième impédance de charge 114 n'est pas court-circuitée par le composant de couplage 116 et la valeur globale de l'impédance de charge de l'oscillateur 100 est donc modifiée par l'ajout de celle de la deuxième impédance de charge 114. Lorsque le composant de couplage 116 est à l'état passant, la deuxième impédance de charge 114 est alors court-circuitée par le composant de couplage 116 et elle ne vient donc pas modifier la valeur globale de l'impédance de charge de l'oscillateur 100. Cette configuration est par exemple applicable pour l'oscillateur 100 précédemment décrit selon le deuxième mode de réalisation, en couplant un deuxième composant inductif en série au composant inductif 146.

Quel que soit son mode de réalisation, l'oscillateur 100 peut être utilisé au sein d'un circuit d'interface 200 pour capteur. La figure 5 représente schématiquement une telle configuration.

Le circuit d'interface 200 comporte un oscillateur 100 verrouillé par injection réalisé selon l'un des modes de réalisation décrits précédemment. L'oscillateur 100 reçoit sur une première entrée un signal de données (correspondant au signal de commande $I_0$ dans les modes de réalisation précédemment décrits) envoyé depuis un amplificateur 350 recevant en entrée un signal de sortie envoyé par un capteur 300. Le circuit d'interface 200 comporte également un oscillateur de référence 202 délivrant un signal de synchronisation périodique de fréquence $f_{synchro}$. Le signal de synchronisation est envoyé sur une deuxième entrée de l'oscillateur 100.

Le signal de synchronisation est également envoyé sur une première entrée d'un dispositif de mesure 400 qui reçoit également, sur une deuxième entrée le signal de sortie délivré par l'oscillateur 100. Le dispositif de mesure 400 détecte le déphasage entre les signaux envoyés sur ses première et deuxième entrées, ce déphasage étant représentatif du signal de données envoyé par le capteur 300. Par exemple, le dispositif de mesure 400 peut comporter une PLL chargée de fournir une fréquence multiple entière de la fréquence de synchronisation et un compteur. La fréquence de comptage est celle du signal issu de la PLL. Le comptage se produit entre le front montant du signal de synchronisation et le front montant du signal issu de l'oscillateur verrouillé par injection.

## Revendications

1. Oscillateur (100) verrouillé par injection comprenant au moins :

   - une ou plusieurs entrées de commande (105) destinées à recevoir un ou plusieurs signaux de commande, l'oscillateur (100) étant configuré tel que la valeur de sa fréquence propre soit fonction de l'amplitude du ou des signaux de commande ;
   - une entrée de synchronisation (107) destinée à recevoir un signal de synchronisation périodique, l'oscillateur (100) étant configuré pour délivrer, lorsque l'oscillateur (100) est verrouillé à la fréquence du signal de synchronisation, un signal de sortie de fréquence égale à la fréquence du signal de synchronisation et tel qu'un déphasage entre le signal de sortie et le signal de synchronisation soit fonction d'une différence entre la fréquence propre de l'oscillateur (100) et la fréquence du signal de synchronisation ;
   - une première impédance de charge (108), l'oscillateur (100) étant configuré tel qu'un signal de charge soit appliqué sur la première impédance de charge (108) ;
   - une deuxième impédance de charge (114) ;
   - un premier composant de couplage (116) configuré pour coupler périodiquement, à la fréquence du signal de synchronisation, et en parallèle ou en série, la deuxième impédance de charge (114) à la première impédance de charge (108).

2. Oscillateur (100) selon la revendication 1, dans lequel l'oscillateur (100) est un oscillateur à relaxation.

3. Oscillateur (100) selon l'une des revendications précédentes, dans lequel le premier composant de couplage (116) comporte au moins un premier transistor de couplage couplé en série ou en parallèle à la deuxième impédance de charge (114).

4. Oscillateur (100) selon l'une des revendications précédentes, comportant en outre au moins :

- une troisième impédance de charge (130), l'oscillateur (100) étant configuré tel que le signal de charge soit appliqué sur la troisième impédance de charge (130) ;
- une quatrième impédance de charge (134) ;
- un deuxième composant de couplage (136) configuré pour coupler périodiquement, à la fréquence du signal de synchronisation, et en parallèle ou en série, la quatrième impédance de charge (134) à la troisième impédance de charge (130).

5. Oscillateur (100) selon la revendication 4, comportant en outre :

- une bascule (102) dont une entrée d'horloge est couplée aux première et deuxième impédances de charge (108, 114), dont une entrée de réinitialisation est couplée aux troisième et quatrième impédances de charge (130, 134), et dont une sortie est configurée pour délivrer le signal de sortie de l'oscillateur (100), ou
- un verrou (101) dont une entrée de mise à un état bas du verrou (101) est couplée aux première et deuxième impédances de charge (108, 114), dont une entrée de mise à un état haut du verrou (101) est couplée aux troisième et quatrième impédances de charge (130, 134), et dont une sortie est configurée pour délivrer le signal de sortie de l'oscillateur (100).

6. Oscillateur (100) selon les revendications 3 et 5, dans lequel une grille du premier transistor de couplage (116) est couplée à une sortie d'une première porte logique NON-OU (118) dont une première entrée est couplée à la sortie de la bascule (102) ou du verrou (101) et dont une deuxième entrée est configurée pour recevoir le signal de synchronisation.

7. Oscillateur (100) selon l'une des revendications 4 à 6, dans lequel le deuxième composant de couplage (136) comporte au moins un deuxième transistor de couplage couplé en série ou en parallèle à la quatrième impédance de charge (134).

8. Oscillateur (100) selon les revendications 5 et 7, dans lequel une grille du deuxième transistor de couplage (136) est couplée à une sortie d'une deuxième porte logique NON-OU (138) dont une première entrée est couplée à une sortie inversée de la bascule (102) ou du verrou (101) et dont une deuxième entrée est configurée pour recevoir un signal inverse du signal de synchronisation.

9. Oscillateur (100) selon l'une des revendications 5 à 8, dans lequel l'oscillateur (100) comporte la bascule (102) ou le verrou (101) et :

- un premier transistor de décharge (104) couplé en parallèle aux première et deuxième impédances de charge (108, 114) et dont la grille est couplée à la sortie de la bascule (102) ou du verrou (101) ;
- un deuxième transistor de décharge (126) couplé en parallèle aux troisième et quatrième impédances de charge (130, 134) et dont la grille est couplée à une sortie inversée de la bascule (102) ou du verrou (101).

10. Oscillateur (100) selon l'une des revendications 5 à 9, dans lequel l'oscillateur (100) comporte la bascule (102) ou le verrou (101) et :

- un premier transistor d'entrée (112) dont une grille est couplée à la sortie de la bascule (102) ou du verrou (101) et configuré tel que le signal de charge, correspondant à un courant de charge, soit appliqué ou non sur la première impédance de charge (108) en fonction de l'état passant ou bloqué du premier transistor d'entrée (112) ;
- un deuxième transistor d'entrée (132) dont une grille est couplée à une sortie inversée de la bascule (102) ou du verrou (101) et configuré tel que le signal de charge soit appliqué ou non sur la troisième impédance de charge (130) en fonction de l'état passant ou bloqué du deuxième transistor d'entrée (132).

11. Oscillateur (100) selon l'une des revendications précédentes, dans lequel l'entrée de commande (105) ou une première des entrées de commande (105) est couplée à la première impédance de charge (108) telle que le signal de commande ou un premier des signaux de commande forme le signal de charge.

12. Oscillateur (100) selon l'une des revendications précédentes, dans lequel :

- la première impédance de charge (108) comporte au moins un premier condensateur et, lorsque l'oscillateur (100) comporte la troisième impédance de charge (130), la troisième impédance de charge (130) comporte au moins un deuxième condensateur, ou

- la première impédance de charge (108) comporte au moins un premier transducteur capacitif formant l'entrée de commande (105) ou une deuxième des entrées de commande (105), la valeur de la fréquence propre de l'oscillateur (100) étant fonction de la valeur de la capacité du premier transducteur capacitif, et, lorsque l'oscillateur (100) comporte la troisième impédance de charge (130), la troisième impédance de charge (130) comporte au moins un deuxième transducteur capacitif formant l'entrée de commande (105) ou la deuxième des entrées de commande (105), la valeur de la fréquence propre de l'oscillateur (100) étant fonction de la valeur de la capacité du deuxième transducteur capacitif.

13. Oscillateur (100) selon l'une des revendications 5 à 12, dans lequel l'oscillateur (100) comporte la bascule (102) ou le verrou (101), et chacune des impédances de charge (108, 114, 130, 134) est couplée à la bascule (102) ou au verrou (101) par l'intermédiaire d'au moins un inverseur dont une entrée de contrôle de tension de seuil forme l'entrée de commande (105) ou une troisième des entrées de commande (105).

14. Oscillateur (100) selon la revendication 1, dans lequel l'oscillateur (100) est un oscillateur harmonique comprenant au moins un circuit LC (108, 114, 146).

15. Oscillateur (100) selon la revendication 1, dans lequel l'oscillateur (100) est un oscillateur en anneau comprenant au moins un nombre d'inverseurs (148, 150, 152) impair et supérieur ou égal à trois, et tels qu'une sortie de l'un des inverseurs (148) soit couplée à la première impédance de charge (108).

16. Oscillateur (100) selon la revendication 15, dans lequel une sortie de chacun des inverseurs (148, 150, 152) est couplée à une impédance de charge (108, 130, 154) et à un composant de couplage (116, 136, 158) configuré pour coupler périodiquement, à la fréquence du signal de synchronisation, et en parallèle ou en série, une autre impédance de charge (114, 134, 156) à ladite impédance de charge (148, 150, 152).

17. Circuit d'interface (200) pour capteur (300), comprenant au moins un oscillateur (100) verrouillé par injection selon l'une des revendications précédentes, et un deuxième oscillateur (202) dont une sortie est couplée à la deuxième entrée (107) de l'oscillateur verrouillé par injection (100).

**Patentansprüche**

1. Injektionsgesperrter Oszillator (100), zumindest enthaltend:

- einen oder mehrere Steuereingänge (105), die dazu bestimmt sind, ein oder mehrere Steuersignale zu empfangen, wobei der Oszillator (100) so ausgelegt ist, dass der Wert seiner Eigenfrequenz Funktion der Amplitude des oder der Steuersignale ist;
- einen Synchronisationseingang (107), der dazu bestimmt ist, ein periodisches Synchronisationssignal zu empfangen, wobei der Oszillator (100) dazu ausgelegt ist, dann, wenn der Oszillator (100) auf die Frequenz des Synchronisationssignals gesperrt ist, ein Ausgangssignal mit einer Frequenz auszugeben, die gleich der Frequenz des Synchronisationssignals ist, so dass eine Phasenverschiebung zwischen dem Ausgangssignal und dem Synchronisationssignal Funktion einer Differenz zwischen der Eigenfrequenz des Oszillators (100) und der Frequenz des Synchronisationssignals ist;
- eine erste Lastimpedanz (108), wobei der Oszillator (100) so ausgelegt ist, dass ein Lastsignal an die erste Lastimpedanz (108) angelegt wird;
- eine zweite Lastimpedanz (114);
- eine erste Kopplungskomponente (116), die dazu ausgelegt ist, periodisch mit der Frequenz des Synchronisationssignals die zweite Lastimpedanz (114) parallel oder in Reihe mit der ersten Lastimpedanz (108) zu koppeln.

2. Oszillator (100) nach Anspruch 1, wobei der Oszillator (100) ein Relaxationsoszillator ist.

3. Oszillator (100) nach einem der vorhergehenden Ansprüche, wobei die erste Koppelungskomponente (116) zumindest einen ersten Koppelungstransistor enthält, der in Reihe oder parallel mit der zweiten Lastimpedanz (114) gekoppelt ist.

4. Oszillator (100) nach einem der vorhergehenden Ansprüche, ferner zumindest enthaltend:

- eine dritte Lastimpedanz (130), wobei der Oszillator (100) so ausgelegt ist, dass das Lastsignal an die dritte Lastimpedanz (130) angelegt wird;
- eine vierte Lastimpedanz (134);
- eine zweite Kopplungskomponente (136), die dazu ausgelegt ist, periodisch mit der Frequenz des Synchronisationssignals die vierte Lastimpedanz (134) parallel oder in Reihe mit der dritten Lastimpedanz (130) zu koppeln.

5. Oszillator (100) nach Anspruch 4, ferner enthaltend:

   - ein Flip-Flop (102) mit einem Takteingang, der mit der ersten und der zweiten Lastimpedanz (108, 114) gekoppelt ist, einem Rücksetzeingang, der mit der dritten und der vierten Lastimpedanz (130, 134) gekoppelt ist, und einem Ausgang, der dazu ausgelegt ist, das Ausgangssignal des Oszillators (100) auszugeben; oder
   - ein Latch (101), wobei ein Latch-Low-Eingang des Latch (101) mit der ersten und der zweiten Lastimpedanz (108, 114) gekoppelt ist, ein Latch-High-Eingang des Latch (101) mit der dritten und der vierten Lastimpedanz (130, 134) gekoppelt ist, und ein Ausgang dazu ausgelegt ist, das Ausgangssignal des Oszillators (100) auszugeben.

6. Oszillator (100) nach Anspruch 3 und 5, wobei ein Gate des ersten Koppelungstransistors (116) mit einem Ausgang eines ersten NOR-Logikgatters (118) gekoppelt ist, von dem ein erster Eingang mit dem Ausgang des Flip-Flop (102) oder des Latch (101) gekoppelt ist und ein zweiter Eingang zum Empfangen des Synchronisationssignals ausgelegt ist.

7. Oszillator (100) nach einem der Ansprüche 4 bis 6, wobei die zweite Koppelungskomponente (136) zumindest einen zweiten Koppelungstransistor enthält, der in Reihe oder parallel mit der vierten Lastimpedanz (134) gekoppelt ist.

8. Oszillator (100) nach Anspruch 5 und 7, wobei ein Gate des zweiten Koppelungstransistors (136) mit einem Ausgang eines zweiten NOR-Logikgatters (138) gekoppelt ist, von dem ein erster Eingang mit einem invertierten Ausgang des Flip-Flop (102) oder des Latch (101) gekoppelt ist und ein zweiter Eingang dazu ausgelegt ist, ein inverses Signal des Synchronisationssignals zu empfangen.

9. Oszillator (100) nach einem der Ansprüche 5 bis 8, wobei der Oszillator (100) das Flip-Flop (102) oder das Latch (101) und

   - einen ersten Entladetransistor (104), der parallel mit der ersten und der zweiten Lastimpedanz (108, 114) gekoppelt ist und dessen Gate mit dem Ausgang des Flip-Flop (102) oder des Latch (101) gekoppelt ist;
   - einen zweiten Entladetransistor (126), der parallel mit der dritten und der vierten Lastimpedanz (130, 134) gekoppelt ist und dessen Gate mit einem invertierten Ausgang des Flip-Flop (102) oder des Latch (101) gekoppelt ist, enthält.

10. Oszillator (100) nach einem der Ansprüche 5 bis 9, wobei der Oszillator (100) das Flip-Flop (102) oder das Latch (101) und

    - einen ersten Eingangstransistor (112), der ein mit dem Ausgang des Flip-Flop (102) oder des Latch (101) gekoppeltes Gate aufweist und so ausgelegt ist, dass das einem Laststrom entsprechende Lastsignal in Abhängigkeit vom Ein- oder Aus-Zustand des ersten Eingangstransistors (112) an die erste Lastimpedanz (108) angelegt wird oder nicht;
    - einen zweiten Eingangstransistor (132), der ein mit einem invertierten Ausgang des Flip-Flop (102) oder des Latch (101) gekoppeltes Gate aufweist und so ausgelegt ist, dass das Lastsignal in Abhängigkeit vom Ein- oder Aus-Zustand des zweiten Eingangstransistors (132) an die dritte Lastimpedanz (130) angelegt wird oder nicht, enthält.

11. Oszillator (100) nach einem der vorhergehenden Ansprüche, wobei der Steuereingang (105) oder ein erster der Steuereingänge (105) mit der ersten Lastimpedanz (108) gekoppelt ist, so dass das Steuersignal oder ein erstes der Steuersignale das Lastsignal bildet.

12. Oszillator (100) nach einem der vorhergehenden Ansprüche, wobei

    - die erste Lastimpedanz (108) zumindest einen ersten Kondensator enthält und, wenn der Oszillator (100) die dritte Lastimpedanz (130) enthält, die dritte Lastimpedanz (130) zumindest einen zweiten Kondensator enthält, oder

- die erste Lastimpedanz (108) zumindest einen ersten kapazitiven Wandler enthält, der den Steuereingang (105) oder einen zweiten der Steuereingänge (105) bildet, wobei der Wert der Eigenfrequenz des Oszillators (100) Funktion von dem Wert der Kapazität des ersten kapazitiven Wandlers ist, und, wenn der Oszillator (100) die dritte Lastimpedanz (130) enthält, die dritte Lastimpedanz (130) zumindest einen zweiten kapazitiven Wandler enthält, der den Steuereingang (105) oder den zweiten der Steuereingänge (105) bildet, wobei der Wert der Eigenfrequenz des Oszillators (100) Funktion von dem Wert der Kapazität des zweiten kapazitiven Wandlers ist.

13. Oszillator (100) nach einem der Ansprüche 5 bis 12, wobei der Oszillator (100) das Flip-Flop (102) oder das Latch (101) enthält und wobei jede der Lastimpedanzen (108, 114, 130, 134) über zumindest einen Inverter, von dem ein Schwellenspannungs-Steuereingang den Steuereingang (105) oder einen dritten der Steuereingänge (105) bildet, mit dem Flip-Flop (102) oder dem Latch (101) gekoppelt ist.

14. Oszillator (100) nach Anspruch 1, wobei der Oszillator (100) ein harmonischer Oszillator ist, der zumindest einen Schwingkreis (108, 114, 146) enthält.

15. Oszillator (100) nach Anspruch 1, wobei der Oszillator (100) ein Ringoszillator ist, der zumindest eine ungerade Anzahl von Invertern (148, 150, 152) enthält, die größer als oder gleich drei ist, und zwar so, dass ein Ausgang eines der Inverter (148) mit der ersten Lastimpedanz (108) gekoppelt ist.

16. Oszillator (100) nach Anspruch 15, wobei ein Ausgang jedes der Inverter (148, 150, 152) mit einer Lastimpedanz (108, 130, 154) und mit einer Kopplungskomponente (116, 136, 158) gekoppelt ist, die dazu ausgelegt ist, periodisch mit der Frequenz des Synchronisationssignals eine weitere Lastimpedanz (114, 134, 156) parallel oder in Reihe mit der Lastimpedanz (148, 150, 152) zu koppeln.

17. Schnittstellenschaltung (200) für einen Sensor (300), enthaltend zumindest einen injektionsgesperrten Oszillator (100) nach einem der vorhergehenden Ansprüche, und einen zweiten Oszillator (202) mit einem Ausgang, der mit dem zweiten Eingang (107) des injektionsgesperrten Oszillators (100) gekoppelt ist.

**Claims**

1. Injection-locked oscillator (100) comprising at least:

   - one or several control inputs (105) configured to receive one or several control signals, the oscillator (100) being configured such that the value of its natural frequency depends on the amplitude of the control signal(s);
   - a synchronisation input (107) configured to receive a periodic synchronisation signal, the oscillator (100) being configured to output an output signal with a frequency equal to the frequency of the synchronisation signal when the oscillator (100) is locked to the frequency of the synchronisation signal, and such that a phase shift between the output signal and the synchronisation signal depends on a difference between the natural frequency of the oscillator (100) and the frequency of the synchronisation signal;
   - a first load impedance (108), the oscillator (100) being configured such that a load signal is applied on the first load impedance (108);
   - a second load impedance (114);
   - a first coupling component (116) configured to periodically couple the second load impedance (114) to the first load impedance (108), at the frequency of the synchronisation signal, in parallel or in series.

2. Oscillator (100) according to claim 1, wherein the oscillator (100) is a relaxation oscillator.

3. Oscillator (100) according to one of previous claims, wherein the first coupling component (116) comprises at least one first coupling transistor coupled in series or in parallel to the second load impedance (114).

4. Oscillator (100) according to one of previous claims, also comprising at least:

   - a third load impedance (130), the oscillator (100) being configured such that the load signal is applied on the third load impedance (130);
   - a fourth load impedance (134);

- a second coupling component (136) configured to periodically couple the fourth load impedance (134) to the third load impedance (130), at the frequency of the synchronisation signal, in parallel or in series.

5. Oscillator (100) according to claim 4, also comprising:

- a flip-flop (102), of which a clock input is coupled to the first and second load impedances (108, 114), including a reset input coupled to the third and fourth load impedances (130, 134), and an output configured to output the oscillator (100) output signal, or
- a lock (101), of which an input setting the lock (101) into the low state is coupled to the first and second load impedances (108, 114), of which an input setting the lock (101) into a high state is coupled to the third and fourth load impedances (130, 134), and of which an output is configured to output the oscillator (100) output signal.

6. Oscillator (100) according to claims 3 and 5, wherein a gate of the first coupling transistor (116) is coupled to an output of a first NOR logic gate (118), a first input of which is coupled to the output of the flip-flop (102) or the lock (101) and a second input of which is configured to receive the synchronisation signal.

7. Oscillator (100) according to one of claims 4 to 6, wherein the second coupling component (136) comprises at least one second coupling transistor coupled in series or in parallel to the fourth load impedance (134).

8. Oscillator (100) according to claims 5 and 7, wherein a gate of the second coupling transistor (136) is coupled to an output of a second NOR logic gate (138), a first input of which is coupled to an inverted output of the flip-flop (102) or the lock (101) and a second input of which is configured to receive an inverted signal of the synchronisation signal.

9. Oscillator (100) according to one of claims 5 to 8, wherein the oscillator (100) comprises the flip-flop (102) or the lock (101) and:

- a first discharge transistor (104) coupled in parallel to the first and second load impedances (108, 114), the gate of which is coupled to the output of the flip-flop (102) or the lock (101);
- a second discharge transistor (126) coupled in parallel to the third and fourth load impedances (130, 134), the gate of which is coupled to an inverted output of the flip-flop (102) or the lock (101).

10. Oscillator (100) according to one of claims 5 to 9, wherein the oscillator (100) comprises the flip-flop (102) or the lock (101) and:

- a first input transistor (112), a gate of which is coupled to the output of the flip-flop (102) or the lock (101) and configured such that the load signal, corresponding to a load current, is or is not applied on the first load impedance (108) as a function of the conducting or blocked state of the first input transistor (112);
- a second input transistor (132), a gate of which is coupled to an inverted output of the flip-flop (102) or the lock (101) and configured such that the load signal is or is not applied on the third load impedance (130) as a function of the conducting or blocked state of the second input transistor (132).

11. Oscillator (100) according to one of previous claims, wherein the control input (105) or a first of the control inputs (105) is coupled to the first load impedance (108) such that the control signal or a first of the control signals forms the load signal.

12. Oscillator (100) according to one of previous claims, wherein:

- the first load impedance (108) comprises at least one first capacitor and, when the oscillator (100) comprises the third load impedance (130), the third load impedance (130) comprises at least one second capacitor, or
- the first load impedance (108) comprises at least one first capacitive transducer forming the control input (105) or a second of the control inputs (105), the value of the natural frequency of the oscillator (100) being a function of the value of the capacitance of the first capacitive transducer, and when the oscillator (100) comprises the third load impedance (130), the third load impedance (130) comprises at least one second capacitive transducer forming the control input (105) or the second of the control inputs (105), the value of the natural frequency of the oscillator (100) being a function of the value of the capacitance of the second capacitive transducer.

13. Oscillator (100) according to one of claims 5 to 12, wherein the oscillator (100) comprises the flip-flop (102) or the lock (101), and each of the load impedances (108, 114, 130, 134) is coupled to the flip-flop (102) or the lock (101) by means of at least one inverter, of which a threshold voltage control input forms the control input (105), or a third of the control inputs (105).

**14.** Oscillator (100) according to claim 1, wherein the oscillator (100) is a harmonic oscillator comprising at least one LC circuit (108, 114, 146).

**15.** Oscillator (100) according to claim 1, wherein the oscillator (100) is a ring oscillator comprising at least an odd number of inverters (148, 150, 152) greater than or equal to three, and such that an output of one of the inverters (148) is coupled to the first load impedance (108).

**16.** Oscillator (100) according to claim 15, wherein an output of each of the inverters (148, 150, 152) is coupled to a load impedance (108, 130, 154) and to a coupling component (116, 136, 158) configured to periodically couple another load impedance (114, 134, 156) to said load impedance (148, 150, 152), at the frequency of the synchronisation signal and in parallel or series.

**17.** Interface circuit (200) for a sensor (300), comprising at least one injection-locked oscillator (100) according to one of previous claims, and a second oscillator (202) of which an output is coupled to the second input (107) of the injection-locked oscillator (100).

FIG.1

FIG.2

FIG.3

FIG.4

FIG.5A

FIG.5B

FIG.6

FIG.7

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3312568 A1